# EUROPÄISCHE PATENTSCHRIFT

(11) **EP 4 327 108 B1**
(45) Veröffentlichungstag und Bekanntmachung des Hinweises auf die Patenterteilung: **21.01.2026**
(21) Anmeldenummer: 22717345.7
(22) Anmeldetag: 12.04.2022
(51) Int. Cl.: G01P 21/00, G01P 15/08, B81C 1/00, G01P 15/097, G01Q 10/04, G01Q 60/38

(54) **MIKRO-ELEKTRO-MECHANISCHES SYSTEM**
MICRO-ELECTROMECHANICAL SYSTEM
SYSTÈME MICRO-ÉLECTROMÉCANIQUE

(30) Priorität: 23.04.2021 AT 503072021
(43) Veröffentlichungstag der Anmeldung: 28.02.2024
(73) Patentinhaber: TECHNISCHE UNIVERSITÄT WIEN, 1040 Wien (AT)
(72) Erfinder: PLATZ, Daniel, 1160 Wien (AT); SCHMID, Ulrich, 1140 Wien (AT); HAFNER, Jonas, 1120 Wien (AT)
(74) Vertreter: Patentanwaltskanzlei Matschnig & Forsthuber OG
(86) Internationale Anmeldenummer: PCT/AT2022/060112
(87) Internationale Veröffentlichungsnummer: WO 2022/221895

(56) Entgegenhaltungen:
- CN-A- 102 539 827
- US-A- 4 338 575
- MOHD-YASIN F ET AL: "TOPICAL REVIEW; Noise in MEMS", MEASUREMENT SCIENCE AND TECHNOLOGY, IOP, BRISTOL, GB, vol. 21, no. 1, 1 January 2010 (2010-01-01), pages 12001, XP020168476, ISSN: 0957-0233

## Beschreibung

Die Erfindung betrifft ein Mikro-Elektro-Mechanisches System (MEMS) umfassend eine Sensorvorrichtung, welche einen Messumformer aufweist, welcher dazu eingerichtet ist, eine physikalische Größe zu messen, wobei der Messumformer zum Messen der physikalischen Größe mechanisch bewegbar ist, wobei der Messumformer in einem ersten Zustand thermische Fluktuationen entsprechend einer effektiven Temperatur T1 aufweist.

Die Erfindung betrifft ferner ein Verfahren zur Herstellung eines Mikro-Elektro-Mechanischen Systems.

MEMS sind Bauteile oder Baugruppen deren kleinste Komponenten Größen im Bereich von wenigen Mikrometern aufweisen. Üblicherweise besteht ein MEMS aus einem oder mehreren Sensoren, Aktoren und einer Steuerungselektronik auf einem Substrat bzw. Chip. Die Sensoren eines MEMS sind beispielsweise Inertialsensoren, z.B. Beschleunigungs- oder Drehsensoren (ein Beschleunigungssensor gemäß dem Stand der Technik ist z.B. in der CN 102539827 A gezeigt). Diese umfassen eine bewegbare Masse (einen Messumformer), welche über ein federndes Element an einem Rahmen oder einer Halterung befestigt ist. Modelliert werden derartige Sensoren als harmonischer Oszillator, mit einer Masse m, einer Federkonstante k, einem Qualitätsfaktor Q und einer Resonanzfrequenz Ω. Die Position der bewegbaren Masse wird üblicherweise kapazitiv oder mit piezoelektrischen Mitteln erfasst. Die MEMS Sensoren können in einem quasi-statischen oder einem resonanten Regime betrieben werden, wobei das quasi-statische Regime häufiger eingesetzt wird. In diesem Regime werden Signale gemessen, welche eine Frequenz unterhalb der Resonanzfrequenz Ω aufweisen. Um eine möglichst hohe Auflösung von MEMS Sensoren zu gewährleisten, ist eine möglichst sensitive Detektion der Auslenkung der bewegbaren Masse erforderlich. Die Messgenauigkeit bzw. die Auflösung des Sensors kann, unter anderem, durch eine Reduktion des thermischen Rauschens (bzw. der thermischen Fluktuationen) der bewegbaren Masse erhöht werden. Eine bekannte Möglichkeit zur Reduktion des thermischen Rauschens bzw. der thermischen Fluktuationen der bewegbaren Masse von Sensoren bilden sogenannte Cavity-optomechanische Beschleunigungssensoren, welche optische Resonatoren aufweisen. Diese sind beispielsweise gezeigt in *"*Krause, A.G., Winger, M., Blasius, T.D., Lin, Q., Painter, O.: A high-resolution microchip optomechanical accelerometer. Nature Photonics 6(11), 768-772 (2012*)".* Bei diesen Sensoren ist es jedoch erforderlich, optischen Resonatoren auf den Sensoren aufzubringen, was zu einer signifikanten Erhöhung der Komplexität des technischen Aufbaus des Sensors führt. Opto-mechanische Systeme sind für Anwendung bei MEMS Sensoren somit nicht praktikabel.

Die Aufgabe der vorliegenden Erfindung besteht darin, die Nachteile des Standes der Technik zu lindern bzw. zu beseitigen. Die Erfindung setzt sich daher insbesondere zum Ziel, ein MEMS zu schaffen, bei welchem die Messgenauigkeit auf einfache und praktikable Weise erhöht wird.

Diese Aufgabe wird durch ein MEMS mit den Merkmalen von Anspruch 1 und ein Verfahren mit den Merkmalen von Anspruch 15 gelöst. Bevorzugte Ausführungen sind in den abhängigen Ansprüchen angegeben.

Erfindungsgemäß weist das MEMS einen Hochfrequenz-Resonator auf, welcher mit der Sensorvorrichtung mechanisch gekoppelt ist, wobei durch die Kopplung der Hochfrequenz-Resonator mit dem Messumformer der Sensorvorrichtung wechselwirken kann, wobei der Hochfrequenz-Resonator als mechanischer Hochfrequenz-Resonator ausgebildet ist, wobei das Mikro-Elektro-Mechanische System einen Energiewandler aufweist, welcher mit dem Hochfrequenz-Resonator wirkverbunden ist, wobei der Energiewandler dazu eingerichtet ist, dass der Hochfrequenz-Resonator durch den Energiewandler in einen ersten Schwingungszustand anregbar ist, wobei der Hochfrequenz-Resonator im angeregten ersten Schwingungszustand eine Übergangsfrequenz aufweist, wobei durch die Wechselwirkung des in der Übergangsfrequenz schwingenden Hochfrequenz-Resonators mit dem Messumformer der Sensorvorrichtung Energie von dem Messumformer auf den Hochfrequenz-Resonator derart übertragbar ist, dass der Messumformer nach dem Energieübertrag einen zweiten Zustand aufweist, in welchem der Messumformer thermische Fluktuationen entsprechend einer effektiven Temperatur T2, welche niedriger als T1 ist, aufweist.

Dadurch ergibt sich der Vorteil, dass thermische Fluktuationen bzw. thermisches Rauschen, durch die Wechselwirkung des Hochfrequenz-Resonators mit dem Messumformer reduziert wird. Die Reduktion der thermischen Fluktuationen erfolgt demnach durch die Wechselwirkung des Messumformers mit einem mechanischen Schwingungssystem. Dieses ist, im Unterschied zu opto-mechanischen Systemen, einfach und kostengünstig mit einem Messumformer koppelbar. Vorzugsweise ist der erste Schwingungszustand unterschiedlich zu dem zweiten Schwingungszustand. Insbesondere weist der erste Schwingungszustand eine andere Frequenz auf als der zweite Schwingungszustand. Die Übergangsfrequenz kann auch als Transferfrequenz bezeichnet werden und ist jene Frequenz, bei welcher Phononen von einer niedrigfrequenten Mode, welche der Messumformer aufweist, auf eine hochfrequente Mode, welche der Hochfrequenz-Resonator aufweist, übergehen. Die Übergangsfrequenz wird insbesondere derart gewählt, dass es zu einem Energietransfer von dem Messumformer auf den Hochfrequenz-Resonator kommt. Der Energietransfer bzw. der Phononentransfer führt zu einer "Kühlung" des Messumformers, oder anders ausgedrückt, zu einer Reduktion der thermischen Fluktuationen, welche durch eine effektive Temperatur charakterisiert sind. Durch die Reduktion der thermischen Fluktuationen wird das Rauschen der Sensorvorrichtung des MEMS reduziert und damit dessen Messgenauigkeit erhöht. Die Übergangsfrequenz ist vorzugsweise verschieden von der Resonanzfrequenz des Messumformers. Der Energiewandler kann zur Anregung ein piezoelektrisches Material bzw. piezoelektrische Dünnschichten aufweisen. Das piezoelektrische Material kann eine Dicke von beispielsweise 100 nm bis 50 µm aufweisen. Das piezoelektrische Material kann mittels einer Elektrodenstruktur mit Energie versorgt werden. Der Hochfrequenz-Resonator kann auch mittels einer kapazitiven Anregung angeregt werden.

Es ist vorgesehen, dass bei dem Energieübertrag von dem Messumformer zu dem Hochfrequenz-Resonator Phononen von ersten Moden zu zweiten Moden transferiert werden, wobei die ersten Moden niederfrequenter sind als die zweiten Moden, wobei der Messumformer die ersten Moden und der Hochfrequenz-Resonator die zweiten Moden aufweist. Durch den Phononentransfer kann eine Reduktion der effektiven Temperatur des Messumformers erreicht werden.

Es kann vorgesehen sein, dass der Energiewandler dazu eingerichtet ist, dass der Hochfrequenz-Resonator durch den Energiewandler in einen zweiten Schwingungszustand anregbar ist, wobei der Hochfrequenz-Resonator im angeregten zweiten Schwingungszustand eine Auslesefrequenz aufweist, welche vorzugsweise von der Übergangsfrequenz verschieden ist, wobei durch die Wechselwirkung des in der Auslesefrequenz schwingenden Hochfrequenz-Resonators mit dem Messumformer der Sensorvorrichtung eine Auslenkung des Messumformers mit dem Hochfrequenz-Resonator messbar ist. Die Auslesefrequenz kann auch gleich der Übergangsfrequenz sein. Die Anregung des Hochfrequenz-Resonators in den zweiten Schwingungszustand ist vorzugsweise eine Alternative zu der Anregung des Hochfrequenz-Resonators in den ersten Schwingungszustand. Das Mikro-Elektro-Mechanisches System ist vorzugsweise in zwei unterschiedlichen Betriebszuständen betreibbar, wobei in einem ersten Betriebszustand die Anregung des Hochfrequenz-Resonators in der Übergangsfrequenz erfolgt. In einem zweiten Betriebszustand kann die Anregung des Hochfrequenz-Resonators in der Auslesefrequenz erfolgen. Der erste Betriebszustand ist vorzugsweise zum Reduzieren der thermischen Fluktuationen des Messumformers vorgesehen und der zweite Betriebszustand ist vorzugsweise zum Messen der Position des Messumformers vorgesehen. Mit anderen Worten ist der zweite Betriebszustand insbesondere ein Zustand, in dem das MEMS ein cavity-assisted-readout ausführen kann.

Es kann vorgesehen sein, dass der Hochfrequenz-Resonator mit dem Messumformer der Sensorvorrichtung zumindest teilweise überlappt. Dadurch kann die Wechselwirkung zwischen dem Hochfrequenz-Resonator und dem Messumformer konstruktiv besonders einfach erzielt werden. Vorzugsweise weist der Hochfrequenz-Resonator und der Messumformer jeweils einen Überlappungsbereich auf, über welchen der Hochfrequenz-Resonator mit dem Messumformer überlappt. Durch den Überlappungsbereich kann eine mechanische Verbindung zwischen dem Hochfrequenz-Resonator und dem Messumformer hergestellt sein. Insbesondere kann der Hochfrequenz-Resonator den Messumformer an dem Überlappungsbereich kontaktieren.

Es kann vorgesehen sein, dass die Anregung des Hochfrequenz-Resonators durch den Energiewandler in einem Bereich mit einem unteren Grenzwert von im Wesentlichen mindestens 10 kHz, vorzugsweise 1 MHz, bevorzugt 100 MHz, besonders bevorzugt 1 GHz und mit einem oberen Grenzwert von im Wesentlichen höchstens 1000 GHz, vorzugsweise 100 GHz, bevorzugt 10 GHz erfolgt. Vorteilhafterweise werden diese Frequenzbereiche bei zahlreichen Sensoren, die in einer Vielzahl von technischen Gebieten eingesetzt werden, verwendet, wodurch das erfindungsgemäße MEMS ein besonders breites Anwendungsgebiet aufweist.

Es kann vorgesehen sein, dass der Energiewandler dazu eingerichtet ist, den Hochfrequenz-Resonator derart anzuregen, dass durch die Anregung mit dem Energiewandler an einer Oberfläche des Messumformers akustische Oberflächenwellen ausgebildet sind. Vorzugsweise weisen die akustischen Oberflächenwellen eine Frequenz auf, welche von der Resonanzfrequenz des Hochfrequenz-Resonators und/oder der Resonanzfrequenz des Messumformers verschieden ist. Vorzugsweise sind die akustischen Oberflächenwellen an jener Oberfläche des Messumformers ausgebildet, welche sich beim Messen einer physikalischen Größe mit der Sensorvorrichtung mechanisch bewegt bzw. eine Positionsänderung erfährt. Vorzugsweise erfolgt die Anregung des Hochfrequenz-Resonators durch den Energiewandler im zweiten Betriebszustand, in welchem der Hochfrequenz-Resonator in den zweiten Schwingungszustand (in der Auslesefrequenz) anregbar ist, derart, dass die akustischen Oberflächenwellen eine Frequenz aufweisen, welche gleich der Resonanzfrequenz des Hochfrequenz-Resonators oder gleich der Resonanzfrequenz des Messumformers ist.

Es kann vorgesehen sein, dass der Energiewandler dazu eingerichtet ist, den Hochfrequenz-Resonator derart anzuregen, dass durch die Anregung mit dem Energiewandler in dem Messumformer Bulk-Moden ausgebildet sind. Vorzugsweise weisen die akustischen Bulk-Moden eine Frequenz auf, welche von der Resonanzfrequenz des Hochfrequenz-Resonators und/oder der Resonanzfrequenz des Messumformers verschieden ist.

Es kann vorgesehen sein, dass die Sensorvorrichtung als Inertialsensor ausgebildet ist. Die Reduktion von thermischen Fluktuationen bzw. thermischen Rauschen ist bei Inertialsensoren von besonders großer Bedeutung. Der Inertialsensor kann beispielsweise einen Beschleunigungssensor, einen Vibrationssensor, einen Drehratensensor oder ein Gyroskop umfassen.

Es kann vorgesehen sein, dass die Sensorvorrichtung einen Beschleunigungssensor mit einer Testmasse umfasst.

Es kann vorgesehen sein, dass der Hochfrequenz-Resonator mit der Testmasse des Beschleunigungssensors zur Schwingungsübertragung gekoppelt ist. Durch die Reduktion des thermischen Rauschens der Testmasse des Beschleunigungssensors, ergibt sich der Vorteil, dass die Messgenauigkeit des Beschleunigungssensors erhöht werden kann.

Es kann vorgesehen sein, dass der Hochfrequenz-Resonator und die Testmasse einstückig ausgebildet sind und der Energiewandler mit der Testmasse derart wirkverbunden ist, dass der Energiewandler die Testmasse in der Übergangsfrequenz anregt und durch die Anregung in der Testmasse Bulk-Moden ausgebildet sind. Die Bulk-Moden können eine Frequenz aufweisen, welche von der Resonanzfrequenz des Hochfrequenz-Resonators und/oder der Testmasse verschieden ist.

Es kann vorgesehen sein, dass die Sensorvorrichtung ein Gyroskop umfasst.

Es kann vorgesehen sein, dass die Sensorvorrichtung einen Cantilever für ein Rasterkraftmikroskop umfasst. Insbesondere ist der Messumformer als Cantilever ausgebildet. Die Sensorvorrichtung kann als Gravimeter ausgebildet sein.

Es kann vorgesehen sein, dass der Hochfrequenz-Resonator eine Oberfläche des Messumformers der Sensorvorrichtung kontaktiert. Durch den Kontakt kann eine einfache und direkte Energieübertragung von dem Messumformer zu dem Hochfrequenz-Resonator erfolgen, um das thermische Rauschen des Messumformers effizient zu reduzieren.

Es kann vorgesehen sein, dass der Messumformer beim Messen in eine Schwingung versetzt wird, welche niedriger als die Übergangsfrequenz ist. Es kann auch vorgesehen sein, dass der Messumformer beim Messen in eine Schwingung versetzt wird, welche niedriger als die Auslesefrequenz ist.

Erfindungsgemäß ist ein Verfahren zur Herstellung des Mikro-Elektro-Mechanischen Systems vorgesehen, wobei das Verfahren die Folgenden Schritte aufweist:
- Bereitstellen eines Substrats;
- Herstellen einer ersten Mikro-Struktur auf dem Substrat, wobei die erste Mikro-Struktur die Sensorvorrichtung umfasst, welche den Messumformer aufweist, welcher dazu eingerichtet ist, die physikalische Größe zu messen, wobei der Messumformer zum Messen der physikalischen Größe mechanisch bewegbar ist,
- Herstellen einer zweiten Mikro-Struktur auf zumindest einem Teilbereich der ersten Mikro-Struktur, wobei die zweite Mikro-Struktur den Hochfrequenz-Resonator umfasst, welcher mit der Sensorvorrichtung mechanisch gekoppelt ist, wobei durch die Kopplung der Hochfrequenz-Resonator mit der Sensorvorrichtung wechselwirken kann,
- Bereitstellten des Energiewandlers, welcher auf der ersten oder zweiten Mikro-Struktur oder auf dem Substrat angeordnet ist, wobei der Energiewandler mit dem Hochfrequenz-Resonator wirkverbunden und dazu eingerichtet ist, den Hochfrequenz-Resonator in einen ersten oder zweiten Schwingungszustand anzuregen, wobei der Hochfrequenz-Resonator in dem ersten Schwingungszustand eine Übergangsfrequenz aufweist, wobei durch die Wechselwirkung des angeregten Hochfrequenz-Resonators mit der Sensorvorrichtung Energie der Sensorvorrichtung auf den Hochfrequenz-Resonator übertragbar ist.

Die Wechselwirkung des angeregten Hochfrequenz-Resonators erfolgt insbesondere mit dem Messumformer der Sensorvorrichtung. Die einzelnen Schritte des erfindungsgemäßen Verfahrens werden mittels in der Halbleitertechnik üblichen Vorrichtungen und Werkzeugen durchgeführt, welche einem Fachmann auf dem Gebiet der Halbleitertechnik bekannt sind.

Es kann vorgesehen sein, dass das Substrat als Wafer ausgebildet ist. Der Wafer ist vorzugsweise ein Siliziumwafer.

Es kann vorgesehen sein, dass die erste und zweite Mikro-Struktur mit einem Fotolithografie-Verfahren hergestellt wird. Vorzugsweise ist auch die erste Mikro-Struktur mit einem Fotolithografie-Verfahren hergestellt.

Im Rahmen dieser Beschreibung sind die Begriffe "oben", "unten", "horizontal", "vertikal" als Angaben der Ausrichtung zu verstehen, wenn das Mikro-Elektro-Mechanisches System in normaler Benutzungsstellung angeordnet ist.

Die Erfindung wird nachstehend anhand eines bevorzugten Ausführungsbeispiels, auf das sie jedoch nicht beschränkt sein soll, noch weiter erläutert. In den Zeichnungen zeigt:
Fig. 1 ein erstes Ausführungsbeispiel eines erfindungsgemäßen MEMS; und
Fig. 2 ein zweites Ausführungsbeispiel eines erfindungsgemäßen MEMS.

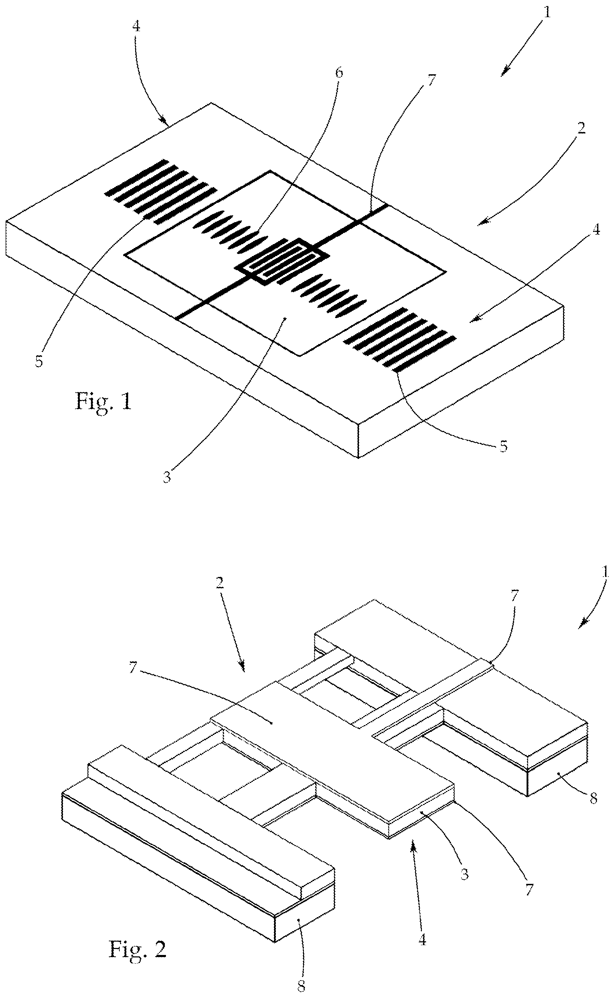

Fig. 1 zeigt ein Ausführungsbeispiels eines erfindungsgemäßen MEMS 1, mit einer Sensorvorrichtung 2, welche einen Messumformer 3 aufweist, welcher dazu eingerichtet ist, eine physikalische Größe zu messen. Der Messumformer 3 ist zum Messen der physikalischen Größe mechanisch bewegbar, wobei der Messumformer 3 in einem ersten Zustand thermische Fluktuationen entsprechend einer effektiven Temperatur T1 aufweist. In dem gezeigten Ausführungsbeispiel der der Messumformer 3 eine Membran.

Das MEMS 1 umfasst einen Hochfrequenz-Resonator 4, welcher mit der Sensorvorrichtung 2 mechanisch gekoppelt ist, wobei durch die Kopplung der Hochfrequenz-Resonator 4 mit dem Messumformer 3 der Sensorvorrichtung 2 wechselwirken kann. Der Hochfrequenz-Resonator 4 ist als mechanischer Hochfrequenz-Resonator 4 ausgebildet. In dem gezeigten Ausführungsbeispiel ist der Hochfrequenz-Resonator 4 durch Bragg-Spiegel 5 gebildet, zwischen welchen akustische Oberflächenwellen 6 ausgebildet werden, wobei diese akustischen Oberflächenwellen 6 an der Oberfläche des Messumformers 3 (der Membran) ausgebildet sind.

Das MEMS 1 weist einen Energiewandler 7 auf, welcher mit dem Hochfrequenz-Resonator 4 wirkverbunden und dazu eingerichtet ist, den Hochfrequenz-Resonator 4 in einen ersten Schwingungszustand anzuregen, wobei der Hochfrequenz-Resonator 4 im angeregten ersten Schwingungszustand eine Übergangsfrequenz aufweist. In dem gezeigten Ausführungsbeispiel ist der Energiewandler 7 ein Interdigitaler Transducer.

Durch die Wechselwirkung des in der Übergangsfrequenz schwingenden Hochfrequenz-Resonators 4 mit dem Messumformer 3 der Sensorvorrichtung 2 ist Energie von dem Messumformer 3 auf den Hochfrequenz-Resonator 4 derart übertragbar, dass der Messumformer 3 nach dem Energieübertrag einen zweiten Zustand aufweist, in welchem der Messumformer 3 thermische Fluktuationen entsprechend einer effektiven Temperatur T2 aufweist. Die Temperatur T2 ist niedriger als T1. Der Messumformer 3 weist somit, durch die Wechselwirkung mit dem Hochfrequenz-Resonator 4, geringere thermische Fluktuationen bzw. ein verringertes thermisches Rauschen auf.

Bei dem Energieübertrag von dem Messumformer 3 zu dem Hochfrequenz-Resonator 4 Phononen von ersten Moden (am Messumformer) zu zweiten Moden (am Hochfrequenz-Resonator) transferiert werden, wobei die ersten Moden niederfrequenter sind als die zweiten Moden.

Fig. 2 zeigt ein zweites Ausführungsbeispiel eines erfindungsgemäßen MEMS 1, wobei der Messumformer 3 als schwingfähiger Balken ausgebildet ist. Der Messumformer 3 ist aus einem piezoelektrischen Material gebildet und der Energiewandler 7 umfasst zwei Elektroden, wobei eine Elektrode vertikal über und eine Elektrode vertikal unter dem Messumformer 3 angeordnet ist. Die Elektroden des Messumformers 7 sind dazu eingerichtet, das piezoelektrische Material zur Schwingung anregen. In dem gezeigten Ausführungsbeispiel werden in dem Messumformer 3 Bulk-Moden ausgebildet. Die untere Elektrode des Energiewandlers ist auf einem Substrat 8 aufgebracht.

In diesem Ausführungsbeispiel sind der Hochfrequenz-Resonator 4 und der Messumformer 3 einstückig ausgebildet und der Energiewandler 7 ist mit dem Messumformer 3 derart wirkverbunden, dass der Energiewandler 7 den Messumformer 3 anregt, wobei durch die Anregung in dem Messumformer 3 Bulk-Moden mit der Übergangsfrequenz oder der Auslesefrequenz ausgebildet sind.

## Patentansprüche

1. Mikro-Elektro-Mechanisches System (1) umfassend:
eine Sensorvorrichtung (2), welche einen Messumformer (3) aufweist, welcher dazu eingerichtet ist, eine physikalische Größe zu messen, wobei der Messumformer (3) zum Messen der physikalischen Größe mechanisch bewegbar ist, wobei der Messumformer (3) in einem ersten Zustand thermische Fluktuationen entsprechend einer effektiven Temperatur T1 aufweist,
**gekennzeichnet durch**
einen Hochfrequenz-Resonator (4), welcher mit der Sensorvorrichtung (2) mechanisch gekoppelt ist, wobei durch die Kopplung der Hochfrequenz-Resonator (4) mit dem Messumformer (3) der Sensorvorrichtung (2) wechselwirken kann,
wobei der Hochfrequenz-Resonator (4) als mechanischer Hochfrequenz-Resonator (4) ausgebildet ist,
wobei das Mikro-Elektro-Mechanische System (1) einen Energiewandler (7) aufweist, welcher mit dem Hochfrequenz-Resonator (4) wirkverbunden ist, wobei der Energiewandler (7) dazu eingerichtet ist, dass der Hochfrequenz-Resonator (4) durch den Energiewandler (7) in einen ersten Schwingungszustand anregbar ist, wobei der Hochfrequenz-Resonator (4) im angeregten ersten Schwingungszustand eine Übergangsfrequenz aufweist,
wobei der Hochfrequenz-Resonator (4) und der Messumformer (3) der Sensorvorrichtung (2) so eingerichtet sind, dass durch die Wechselwirkung des in der Übergangsfrequenz schwingenden Hochfrequenz-Resonators (4) mit dem Messumformer (3) der Sensorvorrichtung (2) Energie von dem Messumformer (3) auf den Hochfrequenz-Resonator (4) derart übertragbar ist, dass der Messumformer (3) nach dem Energieübertrag einen zweiten Zustand aufweist, in welchem der Messumformer (3) thermische Fluktuationen entsprechend einer effektiven Temperatur T2, welche niedriger als T1 ist, aufweist, wobei bei dem Energieübertrag von dem Messumformer (3) zu dem Hochfrequenz-Resonator (4) Phononen von ersten Moden zu zweiten Moden transferiert werden, wobei die ersten Moden niederfrequenter sind als die zweiten Moden, wobei der Messumformer (3) die ersten Moden und der Hochfrequenz-Resonator (4) die zweiten Moden aufweist.

2. Mikro-Elektro-Mechanisches System (1) nach Anspruch 1, wobei der Energiewandler (7) dazu eingerichtet ist, dass der Hochfrequenz-Resonator (4) durch den Energiewandler (7) in einen zweiten Schwingungszustand anregbar ist, wobei der Hochfrequenz-Resonator (4) im angeregten zweiten Schwingungszustand eine Auslesefrequenz aufweist, welche vorzugsweise von der Übergangsfrequenz verschieden ist, wobei durch die Wechselwirkung des in der Auslesefrequenz schwingenden Hochfrequenz-Resonators (4) mit dem Messumformer (3) der Sensorvorrichtung eine Auslenkung des Messumformers (3) mit dem Hochfrequenz-Resonator (4) messbar ist.

3. Mikro-Elektro-Mechanisches System (1) nach einem der vorhergehenden Ansprüche, wobei der Hochfrequenz-Resonator (4) mit dem Messumformer (3) der Sensorvorrichtung (2) zumindest teilweise überlappt.

4. Mikro-Elektro-Mechanisches System (1) nach einem der vorhergehenden Ansprüche, wobei die Anregung des Hochfrequenz-Resonators (4) durch den Energiewandler (7) in einem Bereich mit einem unteren Grenzwert von im Wesentlichen mindestens 10 kHz, vorzugsweise 1 MHz, bevorzugt 100 MHz, besonders bevorzugt 1 GHz und mit einem oberen Grenzwert von im Wesentlichen höchstens 1000 GHz, vorzugsweise 100 GHz, bevorzugt 10 GHz erfolgt.

5. Mikro-Elektro-Mechanisches System (1) nach einem der vorhergehenden Ansprüche, wobei der Energiewandler (7) dazu eingerichtet ist, den Hochfrequenz-Resonator (4) derart anzuregen, dass durch die Anregung mit dem Energiewandler (7) an einer Oberfläche des Messumformers (3) akustische Oberflächenwellen ausgebildet sind.

6. Mikro-Elektro-Mechanisches System (1) nach einem der vorhergehenden Ansprüche, wobei der Energiewandler (7) dazu eingerichtet ist, den Hochfrequenz-Resonator (4) derart anzuregen, dass durch die Anregung mit dem Energiewandler (7) in dem Messumformer (3) Bulk-Moden ausgebildet sind.

7. Mikro-Elektro-Mechanisches System (1) nach einem der vorhergehenden Ansprüche, wobei die Sensorvorrichtung (2) als Inertialsensor ausgebildet ist.

8. Mikro-Elektro-Mechanisches System (1) nach einem der vorhergehenden Ansprüche, wobei die Sensorvorrichtung (2) einen Beschleunigungssensor mit einer Testmasse umfasst, , wobei vorzugsweise der Hochfrequenz-Resonator (4) mit der Testmasse des Beschleunigungssensors zur Schwingungsübertragung gekoppelt ist, wobei vorzugsweise der Hochfrequenz-Resonator (4) und die Testmasse einstückig ausgebildet sind und der Energiewandler (7) mit der Testmasse derart wirkverbunden ist, dass der Energiewandler (7) die Testmasse in der Übergangsfrequenz anregt und durch die Anregung in der Testmasse Bulk-Moden ausgebildet sind.

9. Mikro-Elektro-Mechanisches System (1) nach einem der vorhergehenden Ansprüche, wobei die Sensorvorrichtung (2) ein Gyroskop umfasst.

10. Mikro-Elektro-Mechanisches System (1) nach einem der vorhergehenden Ansprüche, wobei die Sensorvorrichtung (2) einen Cantilever für ein Rasterkraftmikroskop umfasst.

11. Mikro-Elektro-Mechanisches System (1) nach einem der vorhergehenden Ansprüche, wobei der Hochfrequenz-Resonator (4) eine Oberfläche des Messumformers (3) der Sensorvorrichtung (2) kontaktiert.

12. Mikro-Elektro-Mechanisches System (1) nach einem der vorhergehenden Ansprüche, wobei der Messumformer (3) beim Messen in eine Schwingung versetzt wird, welche niedriger als die Übergangsfrequenz ist.

13. Verfahren zur Herstellung eines Mikro-Elektro-Mechanischen Systems (1) nach einem der vorhergehenden Ansprüche, wobei das Verfahren die Folgenden Schritte aufweist:
- Bereitstellen eines Substrats;
- Herstellen einer ersten Mikro-Struktur auf dem Substrat, wobei die erste Mikro-Struktur die Sensorvorrichtung (2) umfasst, welche den Messumformer (3) aufweist, welcher dazu eingerichtet ist, die physikalische Größe zu messen, wobei der Messumformer (3) zum Messen der physikalischen Größe mechanisch bewegbar ist,
- Herstellen einer zweiten Mikro-Struktur auf zumindest einem Teilbereich der ersten Mikro-Struktur, wobei die zweite Mikro-Struktur den Hochfrequenz-Resonator (4) umfasst, welcher mit der Sensorvorrichtung (2) mechanisch gekoppelt ist, wobei durch die Kopplung der Hochfrequenz-Resonator (4) mit der Sensorvorrichtung (2) wechselwirken kann,
- Bereitstellten des Energiewandlers (7), welcher auf der ersten oder zweiten Mikro-Struktur oder auf dem Substrat angeordnet ist, wobei der Energiewandler (7) mit dem Hochfrequenz-Resonator (4) wirkverbunden und dazu eingerichtet ist, den Hochfrequenz-Resonator (4) in einen ersten oder zweiten Schwingungszustand anzuregen, wobei der Hochfrequenz-Resonator (4) in dem ersten Schwingungszustand eine Übergangsfrequenz aufweist,
wobei durch die Wechselwirkung des angeregten Hochfrequenz-Resonators (4) mit der Sensorvorrichtung (2) Energie der Sensorvorrichtung (2) auf den Hochfrequenz-Resonator (4) übertragbar ist.

14. Verfahren nach Anspruch 13, wobei das Substrat als Wafer ausgebildet ist.

15. Verfahren nach Anspruch 13 oder 14, wobei die erste und zweite Mikro-Struktur mit einem Fotolithografie-Verfahren hergestellt wird.

## Claims

1. Micro-electro-mechanical system (1) comprising:
a sensor device (2) comprising a transducer (3) configured to measure a physical quantity,
wherein the transducer (3) is mechanically movable for measuring the physical quantity, wherein
the transducer (3) in a first state has thermal fluctuations corresponding to an effective temperature T1,
**characterized by**
a high-frequency resonator (4) mechanically coupled to the sensor device (2), wherein the coupling enables the high-frequency resonator (4) to interact with the transducer (3) of the sensor device (2),
wherein the high-frequency resonator (4) is realized as a high-frequency mechanical resonator (4),
wherein the micro-electro-mechanical system (1) comprises an energy converter (7) which is operationally connected with the high-frequency resonator (4), the energy converter (7) being configured to excite the high-frequency resonator (4) into a first oscillation state by the energy converter (7), the high-frequency resonator (4), when in the excited first oscillation state, having a transition frequency,
wherein the high-frequency resonator (4) and the transducer (3) of the sensor device (2) are configured such that, by virtue of the interaction of the high-frequency resonator (4) oscillating at the transition frequency, energy is transmitted using the transducer (3) of the sensor device (2) from the transducer (3) to the high-frequency resonator (4) in such a way that the transducer (3) is, after the energy transfer, in a second state in which the transducer (3) exhibits thermal fluctuations corresponding to an effective temperature T2 lower than T1, wherein during the energy transfer from the measuring transducer (3) to the high-frequency resonator (4), phonons are transferred from first modes to second modes, the first modes having lower frequency than the second modes, wherein the transducer (3) comprises the first modes and the high-frequency resonator (4) comprises the second modes.

2. Micro-electro-mechanical system (1) according to claim 1, wherein the energy converter (7) is configured to excite the high-frequency resonator (4) into a second oscillation state, wherein in the excited second oscillation state the high-frequency resonator (4) comprises a readout frequency which is preferably different from the transition frequency, wherein, by virtue of the interaction of the high-frequency resonator (4) oscillating at the readout frequency with the transducer (3) of the sensor device, the high-frequency resonator (4) is enabled to measure a deflection of the transducer (3).

3. Micro-electro-mechanical system (1) according to any one of the preceding claims, wherein the high-frequency resonator (4) at least partially overlaps with the transducer (3) of the sensor device (2).

4. Micro-electro-mechanical system (1) according to any one of the preceding claims, wherein the excitation of the high-frequency resonator (4) by the energy converter (7) is in a range with a lower limit of substantially at least 10 kHz, preferably 1 MHz, preferably 100 MHz, more preferably 1 GHz, and with an upper limit of substantially at most 1000 GHz, preferably 100 GHz, preferably 10 GHz.

5. Micro-electro-mechanical system (1) according to any one of the preceding claims, wherein the energy converter (7) is configured to excite the high-frequency resonator (4) in such a way that acoustic surface waves are formed on a surface of the measuring transducer (3) as a result of the excitation by the energy converter (7).

6. Micro-electro-mechanical system (1) according to any one of the preceding claims, wherein the energy converter (7) is configured to excite the high-frequency resonator (4) in such a way that bulk modes are formed in the measuring transducer (3) by the excitation with the energy converter (7).

7. Micro-electro-mechanical system (1) according to any one of the preceding claims, wherein the sensor device (2) is realized as an inertial sensor.

8. Micro-electro-mechanical system (1) according to any one of the preceding claims, wherein the sensor device (2) comprises an acceleration sensor having a test mass, wherein preferably the high-frequency resonator (4) is coupled to the test mass of the acceleration sensor for vibration transmission, wherein preferably the high-frequency resonator (4) and the test mass are formed in one piece and the energy converter (7) is operatively connected to the test mass such that the energy converter (7) excites the test mass at the transition frequency and bulk modes are formed in the test mass as a result of the excitation.

9. Micro-electro-mechanical system (1) according to any one of the preceding claims, wherein the sensor device (2) comprises a gyroscope.

10. Micro-electro-mechanical system (1) according to any one of the preceding claims, wherein the sensor device (2) comprises a cantilever for an atomic force microscope.

11. Micro-electro-mechanical system (1) according to any one of the preceding claims, wherein the high-frequency resonator (4) contacts a surface of the transducer (3) of the sensor device (2).

12. Micro-electro-mechanical system (1) according to any one of the preceding claims, wherein the transducer (3) is caused to oscillate during measurement, at oscillations lower than the transition frequency.

13. Method for manufacturing a micro-electro-mechanical system (1) according to any one of the preceding claims, wherein the method comprises the steps of:
- providing a substrate;
- producing a first microstructure on the substrate, the first microstructure including the sensor device (2) comprising the transducer (3) configured to measure the physical quantity, wherein the transducer (3) is mechanically movable for measuring the physical quantity,
- producing a second microstructure on at least a portion of the first microstructure, wherein the second microstructure comprises the high-frequency resonator (4), which is mechanically coupled to the sensor device (2), wherein the coupling enables the high-frequency resonator (4) to interact with the sensor device (2),
- providing the energy converter (7), which is arranged on the first or second microstructure or on the substrate, wherein the energy converter (7) is operatively connected to the high-frequency resonator (4) and is configured to excite the high-frequency resonator (4) into a first or second oscillation state, the high-frequency resonator (4) having a cut-off frequency in the first oscillation state,
wherein the interaction of the excited high-frequency resonator (4) with the sensor device (2) enables transferring energy from the sensor device (2) to the high-frequency resonator (4).

14. Method according to claim 13, wherein the substrate is realized as a wafer.

15. Method according to claim 13 or 14, wherein the first and second microstructures are produced using a photolithography process.

## Revendications

1. Système micro-électromécanique (1) comprenant :
un dispositif capteur (2) qui comporte un transducteur (3) qui est conçu pour mesurer une grandeur physique, le transducteur (3) pouvant être déplacé mécaniquement pour mesurer la grandeur physique, le transducteur (3) présentant, dans un premier état, des fluctuations thermiques correspondant à une température effective T1,
**caractérisé par**
un résonateur haute fréquence (4) qui est couplé mécaniquement au dispositif capteur (2) et par ce couplage le résonateur haute fréquence (4) peut interagir avec le transducteur (3) du dispositif capteur (2),
le résonateur haute fréquence (4) étant conçu comme un résonateur mécanique haute fréquence (4),
le système micro-électromécanique (1) comportant un convertisseur d'énergie (7) qui est relié de manière opérationnelle au résonateur haute fréquence (4), le convertisseur d'énergie (7) étant configuré pour exciter le résonateur haute fréquence (4) dans un premier état d'oscillation, le résonateur haute fréquence (4) présentant une fréquence de transition dans le premier état d'oscillation excité,
le résonateur haute fréquence (4) et le transducteur (3) du dispositif capteur (2) étant agencés de telle sorte que l'interaction entre le résonateur haute fréquence (4) oscillant à la fréquence de transition et le transducteur (3) du dispositif capteur (2) permet de transférer de l'énergie du transducteur (3) au résonateur haute fréquence (4) de telle sorte qu'après le transfert d'énergie, le transducteur (3) présente un deuxième état dans lequel le transducteur (3) présente des fluctuations thermiques correspondant à une température effective T2 qui est inférieure à T1,
pendant le transfert d'énergie du transducteur de mesure (3) vers le résonateur haute fréquence (4) des phonons étant transférés de premiers modes vers des seconds modes, les premiers modes étant de plus basse fréquence que les seconds modes, le transducteur (3) présentant les premiers modes et le résonateur haute fréquence (4) présentant les seconds modes.

2. Système micro-électromécanique (1) selon la revendication 1, dans lequel le convertisseur d'énergie (7) est conçu de telle sorte que le résonateur haute fréquence (4) est excitable par le convertisseur d'énergie (7) dans un deuxième état d'oscillation, le résonateur haute fréquence (4) comportant, dans le deuxième état d'oscillation excité, une fréquence de lecture qui est de préférence différente de la fréquence de transition, par lequel grâce à l'interaction entre le résonateur haute fréquence (4) oscillant à la fréquence de lecture et le transducteur (3) du dispositif capteur, une déviation du transducteur (3) avec le résonateur haute fréquence (4) peut être mesurée.

3. Système micro-électromécanique (1) selon l'une quelconque des revendications précédentes, le résonateur haute fréquence (4) chevauchant au moins partiellement le transducteur (3) du dispositif capteur (2).

4. Système micro-électromécanique (1) selon l'une quelconque des revendications précédentes, dans lequel l'excitation du résonateur haute fréquence (4) par le convertisseur d'énergie (7) se situe dans une plage avec une limite inférieure de substantiellement au moins 10 kHz, de préférence 1 MHz, de préférence 100 MHz, plus préférée 1 GHz, et avec une valeur limite supérieure de substantiellement au moins 1000 GHz, de préférence 100 GHz, de préférence 10 GHz.

5. Système micro-électromécanique (1) selon l'une quelconque des revendications précédentes, dans lequel le convertisseur d'énergie (7) est conçu pour exciter le résonateur haute fréquence (4) de telle sorte que l'excitation par le convertisseur d'énergie (7) génère des ondes acoustiques de surface sur une surface du transducteur (3).

6. Système micro-électromécanique (1) selon l'une quelconque des revendications précédentes, dans lequel le convertisseur d'énergie (7) est conçu pour exciter le résonateur haute fréquence (4) de telle sorte que l'excitation par le convertisseur d'énergie (7) forme des modes de volume dans le transducteur (3).

7. Système micro-électromécanique (1) selon l'une quelconque des revendications précédentes, dans lequel le dispositif capteur (2) est conçu comme un capteur inertiel.

8. Système micro-électromécanique (1) selon l'une quelconque des revendications précédentes, dans lequel le dispositif capteur (2) comprend un capteur d'accélération avec une masse d'essai, le résonateur haute fréquence (4) étant de préférence couplé à la masse d'essai du capteur d'accélération pour la transmission des vibrations, le résonateur haute fréquence (4) et la masse d'essai étant réalisés d'un seul tenant et le convertisseur d'énergie (7) étant relié de manière fonctionnelle à la masse d'essai de telle sorte que le convertisseur d'énergie (7) excite la masse d'essai à la fréquence de transition et que des modes de volume sont formés dans la masse d'essai par l'excitation.

9. Système micro-électromécanique (1) selon l'une quelconque des revendications précédentes, dans lequel le dispositif capteur (2) comprend un gyroscope.

10. Système micro-électromécanique (1) selon l'une quelconque des revendications précédentes, dans lequel le dispositif capteur (2) comprend un cantilever pour un microscope à force atomique.

11. Système micro-électromécanique (1) selon l'une quelconque des revendications précédentes, dans lequel le résonateur haute fréquence (4) est en contact avec une surface du transducteur (3) du dispositif capteur (2).

12. Système micro-électromécanique (1) selon l'une quelconque des revendications précédentes, dans lequel le transducteur (3) est mis en vibration lors de la mesure, laquelle vibration est inférieure à la fréquence de transition.

13. Procédé de fabrication d'un système microélectromécanique (1) selon l'une quelconque des revendications précédentes, le procédé comprenant les étapes de :
- fournir un substrat ;
- produire une première microstructure sur le substrat, la première microstructure comprenant le dispositif capteur (2) qui comporte le transducteur (3) qui est conçu pour mesurer la grandeur physique, le transducteur (3) pouvant être déplacé mécaniquement pour mesurer la grandeur physique,
- produire une deuxième microstructure sur au moins une partie de la première microstructure, la deuxième microstructure comprenant le résonateur haute fréquence (4) qui est couplé mécaniquement au dispositif capteur (2), ce couplage permettant au résonateur haute fréquence (4) d'interagir avec le dispositif capteur (2),
- fournir le convertisseur d'énergie (7) qui est disposé sur la première ou la deuxième microstructure ou sur le substrat, le convertisseur d'énergie (7) étant relié de manière fonctionnelle au résonateur haute fréquence (4) et étant conçu pour exciter le résonateur haute fréquence (4) dans un premier ou un deuxième état d'oscillation, le résonateur haute fréquence (4) ayant une fréquence de transition dans le premier état d'oscillation,
dans lequel l'énergie du dispositif capteur (2) peut être transférée au résonateur haute fréquence (4) par l'interaction du résonateur haute fréquence excité (4) avec le dispositif capteur (2).

14. Procédé selon la revendication 13, le substrat étant réalisé sous forme de wafer.

15. Procédé selon la revendication 13 ou 14, les première et deuxième microstructures étant produites à l'aide d'un procédé de photolithographie.
